# EUROPÄISCHE PATENTSCHRIFT

(11) **EP 3 133 014 B1**
(45) Veröffentlichungstag und Bekanntmachung des Hinweises auf die Patenterteilung: **28.11.2018**
(21) Anmeldenummer: 16001567.3
(22) Anmeldetag: 15.07.2016
(51) Int. Cl.: B64C 23/00, H01L 27/20

(54) **MIKROELEKTRONISCHES MODUL, MODULARRAY UND VERFAHREN ZUR STRÖMUMGSBEEINFLUSSUNG**
MICRO-ELECTRONIC MODULE, MODULE ARRAY, AND METHOD FOR INFLUENCING FLUID CURRENT
MODULE MICRO-ÉLECTRONIQUE, RÉSEAU MODULAIRE ET MÉTHODE POUR INFLUENCER UN COURANT FLUIDIQUE

(30) Priorität: 12.08.2015 DE 102015010233
(43) Veröffentlichungstag der Anmeldung: 22.02.2017
(73) Patentinhaber: Airbus Defence and Space GmbH, 82024 Taufkirchen (DE)
(72) Erfinder: Caspari, Ralf, 85092 Kösching (DE); Weichwald, Robert, 93354 Siegenburg (DE); Ermann, Emanuel, 85077 Oberstimm (DE); Bauer, Karin, 82041 Oberhaching (DE)
(74) Vertreter: LKGLOBAL Lorenz & Kopf PartG mbB Patentanwälte

(56) Entgegenhaltungen:
- WO-A2-2009/124913
- US-A1- 2007 216 735
- US-A1- 2012 193 483

## Beschreibung

Die Erfindung betrifft ein mikroelektronisches Modul zur Beeinflussung einer Strömung eines Fluiden, sowie ein Modularray und ein Verfahren zur Beeinflussung einer Strömung eines Fluiden.
Die Entwicklung modernder Fahrzeuge, beispielsweise moderner Flugzeuge, geht immer weiter dahin, die Kosten für den laufenden Betrieb zu senken. Ein großer Kostenfaktor ist hierbei beispielsweise der Kerosinverbrauch. Um den Kerosinverbrauch beispielsweise bei einem Flugzeug zu reduzieren, wird u.a. versucht die Aerodynamik des Flugzeugs zu verbessern. Dies geschieht beispielsweise im Bereich der Tragflächen durch sogenannte Winglets bzw. Sharklets oder durch eine besondere Strukturierung von Teilen der Tragflächenvorderkanten um den Strömungswiderstand des Flugzeugs zu verringern. Derartige Verbesserungen beruhen häufig auf einem passiven Effekt, der beispielsweise bei sogenannten Riblets auf eine Verminderung des Reibungswiderstands auf turbulent überströmten Oberflächen beruhen. Riblets nutzen hierzu eine besondere Oberflächengeometrie aus Rippen aus, mit deren Hilfe sich turbulente Strömungen an einer überströmten Oberfläche, und damit Reibungsverluste, reduzieren lassen. Diese Verbesserungen weisen jedoch den Nachteil auf, dass diese häufig nur passiv wirken und in der Richtung nicht variabel sind.

US 2012/193483 A1 offenbart ein Modul zur Beeinflussung der Grenzflächenströmung, beispielsweise auf Flugzeugtragflächen, das Plasma-Aktuatoren als aktive Strömungsbeeinflussungselemente aufweist. Ein ähnliches Modul lehrt WO 2009/124913 A2, allerdings mit mikromechanischen Membranen, die von Piezoaktoren mit Hebelverstärkung bewegt werden, als aktive Strömungsbeeinflussungselemente.

Davon ausgehend ist es Aufgabe der Erfindung, eine Vorrichtung anzugeben, die die vorgenannten Nachteile vermeidet.
Diese Aufgabe wird mit einer Vorrichtung mit den Merkmalen des Anspruchs 1 gelöst. Beispielhafte Ausführungsformen sind in den abhängigen Ansprüchen dargestellt. Es sei darauf hingewiesen, dass die Merkmale der Ausführungsbeispiele der Vorrichtungen auch für Ausführungsformen des Verfahrens sowie Verwendung der Vorrichtung gelten und umgekehrt.
Es wird ein mikroelektronisches Modul zur Beeinflussung einer Strömung eines Fluiden angegeben. Das Modul weist wenigstens einen Spannungswandler zur Umwandlung einer bereitgestellten ersten Spannung in eine höhere oder niedrigere zweite Spannung auf. Weiter weist das Modul wenigstens ein aktives Strömungsbeeinflussungselement, zur Beeinflussung der Richtung und/oder der Geschwindigkeit eines das aktive Strömungsbeeinflussungselement um- und/oder überströmenden Fluiden auf. Wenigstens der Spannungswandler und das aktive Strömungsbeeinflussungselement sind auf einem dünnschichtigen flächigen Substrat angeordnet. Die Beeinflussung der Richtung und/oder der Geschwindigkeit des Fluiden ist abhängig von einer hydrodynamischen Beschleunigung in Abhängigkeit von der von dem Spannungswandler bereitgestellten zweiten Spannung an das aktive Strömungsbeeinflussungselement.
Der Erfindung liegt der Gedanke zugrunde, die Richtung und/oder der Geschwindigkeit eines eine Oberfläche um- oder überströmenden Fluiden durch eine hydrodynamische Beschleunigung, die durch eine an einem aktiven Strömungsbeeinflussungselement anliegende Spannung erzeugt wird, zu beeinflussen. Hierbei kann die Richtung und/oder Geschwindigkeit des Fluiden im Bereich des aktiven Strömungsbeeinflussungselements verändert werden, d.h. die Richtung verändert und/oder die Geschwindigkeit erniedrigt oder erhöht werden. Durch Integration der hierfür notwendigen Bauteile in einem sehr kleinen Maßstab auf einer Folie, kann das Modul beispielsweise leicht auf einer Oberfläche eines Fahrzeugs aufgebracht werden, um den an der Oberfläche vorbeiströmenden Fluiden in Richtung und/oder Geschwindigkeit zu beeinflussen, um damit die Um- bzw. Überströmung des Fluiden an der Oberfläche zu verbessern, d.h. beispielsweise einen Strömungswiderstand zu reduzieren oder wenn erwünscht, auch zu erhöhen. Dadurch lässt sich beispielsweise der Kerosinverbrauch eines Flugzeugs, das beispielsweise eine Mehrzahl dieser Modul beispielsweise an einer Tragflächenvorderkante aufweist, reduzieren.
Die Bezeichnung "aktives Strömungsbeeinflussungselement" kann als jedes elektrische Element verstanden werden, das in der Lage ist mit Hilfe einer angelegten Spannung aktiv eine hydrodynamische Beschleunigung zu erzeugen. Die Bezeichnung "Spannungswandler" kann als jedes elektrische Element verstanden werden, das in der Lage ist, eine Eingangsspannung in eine höhere oder niedrigere Ausgangsspannung umzuwandeln. Gemäß einer bevorzugten Ausführungsform ist das mikroelektronische Modul ein MEMS (Micro-Elektro-Mechanisches System) Modul, d.h. in MEMS-Bauweise ausgeführt. Alternativ kann das Modul auch als nanoelektromechanisches System ausgebildet sein.
Gemäß einer bevorzugten Ausführungsform weist der Spannungswandler des mikroelektronischen Moduls einen piezoelektrischen Transformator auf. Dies hat den Vorteil, dass piezoelektrische Transformatoren in einem sehr kleinen Maßstab gefertigt werden können.
Gemäß einer bevorzugten Ausführungsform ist das Fluid Luft, Öl oder Wasser. Durch das Strömungsbeeinflussungselement lassen sich die Richtung und/oder die Geschwindigkeit von an einer Oberfläche um- oder vorbeiströmenden Luft, Öl oder Wasser beeinflussen. Dies hat den Vorteil, dass sich beispielsweise ein Strömungswiderstand an einer Oberfläche reduzieren oder wenn erwünscht, auch erhöhen lässt.
Gemäß einer bevorzugten Ausführungsform weist das aktive Strömungsbeeinflussungselement einen asymmetrisch aufgebauten Kondensator auf. Bei einem asymmetrisch aufgebauten Kondensator lässt sich durch Anlegen einer Spannung ein lonenstrom im Bereich des Kondensators erzeugen. Der lonenstrom ist Abhängig von der Spannung, die an dem Kondensator anliegt. Vorzugsweise liegt an dem Kondensator eine Spannung kurz unterhalb der Überschlagsspannung des Kondensators an. Durch den lonenstrom kann gleichzeitig ein Fluid in der direkten Umgebung des lonenstroms, d.h. des Kondensators beeinflusst werden, d.h. durch den lonenstrom in einer bestimmten Richtung verändert werden. Dies hat den Vorteil, dass durch den lonenstrom, ein Fluid in der Umgebung des Kondensators in seiner Richtung und/oder Geschwindigkeit aktiv beeinflusst werden kann.

Die Elektroden des Kondensators können nahezu jede beliebige Form, Anordnung, Anzahl aufweisen oder aus nahezu jedem beliebigen Material bestehen, das geeignet ist, einen lonenstrom zu erzeugen, der geeignet ist, ein die Elektroden umströmendes oder überströmendes Fluid in seiner Richtung und/oder Geschwindigkeit zu beeinflussen.

Gemäß einer bevorzugten Ausführungsform wird die bereitgestellte erste Spannung für den Spannungswandler wenigstens teilweise über eine externe Spannungsquelle bereitgestellt. Beispielsweise wird die erste Spannung von einer Spannungsquelle außerhalb des Moduls bereitgestellt. Beispielsweise kann die Spannungsquelle ein Energieerzeugungselement sein, das wie das Modul auf einer Oberfläche aufgebracht ist. Alternativ kann das Energieerzeugungselement auch beispielsweise eine Antriebsvorrichtung eines Fahrzeugs sein, auf dessen Oberfläche das Modul angebracht ist. Dies hat den Vorteil, dass das Modul in seinen geometrischen Abmessungen sehr gering gehalten werden kann.

Gemäß einer bevorzugten Ausführungsform weist das Substrat weiter ein Energieerzeugungselement zur Erzeugung wenigstens eines Teils der bereitzustellenden ersten Spannung auf. Auf dem Substrat können beispielsweise ein oder mehrere Energieerzeugungselemente gleicher oder unterschiedlicher Art angeordnet sein, die die erste Spannung für das Modul bereitstellen. Zusätzlich zu dem wenigstens einen Energieerzeugungselement auf dem Substrat kann das Modul auch einen Anschluss zur Bereitstellung wenigstens eines Teils der ersten Spannung durch eine externe Spannungsquelle aufweisen. Dies hat den Vorteil, dass das Modul wenigstens teilweise oder ganz autark von einer externen Spannungsquelle ist. Dies hat den weiteren Vorteil, dass das Modul flexibel in der Anbringen an oder auf beliebigen Oberflächen ist.
Gemäß einer bevorzugten Ausführungsform weist das Substrat weiter ein Energieerzeugungselement zur Erzeugung wenigstens eines Teils der bereitzustellenden ersten Spannung auf, wobei das Energieerzeugungselement eine Solarzellenanordnung aufweist. Alternativ kann das Energieerzeugungselement auch eine anderweitige geeignete Vorrichtung zur Erzeugung von elektrischer Energie aufweisen. Dies hat den Vorteil, dass das Modul vorzugsweise unabhängig ist von einer externen Spannungsquelle und autark betrieben werden kann. Dies hat den weiteren Vorteil, dass das Modul flexibel in dem Anbringen an beliebigen Oberflächen ist. Bei der Anbringung des Moduls auf einer Oberfläche eines Flugzeugs eignet sich eine Solarzellenanordnung für die Erzeugung elektrischer Energie, da ein Flugzeug in der Flugphase vorzugsweise oberhalb der Wolkenschicht fliegt und dadurch keine Abschattung der Sonne durch Wolken ausgesetzt ist.
Gemäß einer bevorzugten Ausführungsform ist das dünnschichtige flächige Substrat eine flexible und/oder mehrdimensional verformbare Folie oder ein Gitter.
Beispielsweise kann das Gitter eine flexible und/oder mehrdimensional verformbare Gitterstruktur aufweisen. Das dünnschichtige flächige Substrat kann alternativ auch aus einem vergleichbaren Material bestehen, das geeignet ist, das die Bauteile des Moduls auf diesem auf-, ein- bzw. angebracht werden können und das möglichst dünn und stabil genug ist. Beispielsweise kann das Substrat auch ein Gewebe oder eine Gitterstruktur oder einen Verbundwerkstoff aufweisen. Dies hat den Vorteil, dass das Modul in seinen geometrischen Abmessungen gering gehalten werden kann, wobei eine ausreichende Stabilität gegeben ist, um das Modul beispielsweise auf einer Oberfläche dauerhaft oder reversibel aufzubringen, beispielsweise zu kleben.

Gemäß einer bevorzugten Ausführungsform weist das Modul eine Mehrzahl von aktiven Strömungsbeeinflussungselementen auf. Die Mehrzahl der aktiven Strömungsbeeinflussungselemente weist eine unterschiedliche und/oder identische Orientierung auf.

Gemäß einer weiteren bevorzugten Ausführungsform weist das Modul eine Mehrzahl von aktiven und/oder wenigstens ein passives Strömungsbeeinflussungselement auf. Die Mehrzahl der aktiven und/oder passiven Strömungsbeeinflussungselemente weist eine unterschiedliche und/oder identische Orientierung auf.

Genauer gesagt ist die Beeinflussungsrichtung, d.h. Orientierung der aktiven bzw. der aktiven und/oder passiven Strömungsbeeinflussungselemente, des Fluiden im Bereich der Strömungsbeeinflussungselemente unterschiedlich und/oder identisch. Dies hat den Vorteil, dass ein Fluid im Bereich der aktiven Strömungsbeeinflussungselemente durch gezieltes aktivieren und/oder deaktivieren einzelner oder mehrerer Strömungsbeeinflussungselemente in seiner Richtung und/oder Geschwindigkeit nahezu beliebig beeinflussen lässt.

Unter einem passiven Strömungsbeeinflussungselement ist eine passive Struktur zu verstehen, die geeignet ist, um den generierten Effekt zu unterstützen oder zu verstärken. Passive Strukturen können 3D mikrotechnische passive und / oder resonante Strukturen sein, die die generierte Strömung lokal beeinflussen, vorzugsweise verwirbeln oder lokal umlenken können. Gemäß einer Ausführungsform sind die passiven Strukturen Teil des mikroelektrischen Moduls. Gemäß einer alternativen Ausführungsform sind die passiven Strukturen eine eigene Komponente des Strömungsbeeinflussungselements.

Gemäß einer bevorzugten Ausführungsform bestimmt die Orientierung, eine zeitlich abhängige und/oder eine spannungsamplitudenabhängige Ansteuerung der Mehrzahl von aktiven Strömungsbeeinflussungselementen und/oder die Orientierung der passiven Strömungsbeeinflussungselemente die Richtung der Beeinflussung auf den Fluiden. Durch die Orientierung, eine zeitlich abhängige und/oder eine spannungsamplitudenabhängige Ansteuerung der Mehrzahl von Strömungsbeeinflussungselementen lässt sich die Richtung der Beeinflussung auf den Fluiden steuern. Dies hat den Vorteil, dass ein Fluid gezielt in seiner Richtung und/oder Geschwindigkeit beeinflusst werden kann.

Gemäß einer bevorzugten Ausführungsform des Moduls aufweisend eine Mehrzahl von Strömungsbeeinflussungselementen kann das Modul ein oder mehrere Schaltelemente aufweisen, die eingerichtet sind, ein oder mehrere Strömungsbeeinflussungselemente der Mehrzahl von Strömungsbeeinflussungselementen zu aktivieren und/oder zu deaktivieren. Dies hat den Vorteil, dass das Modul individuell gesteuert werden kann und die geometrischen Abmessungen je nach Anwendung gering gehalten werden können.

Gemäß einer bevorzugten Ausführungsform weist das Modul wenigstens einen Empfänger auf. Der Empfänger ist eingerichtet ein Signal zu empfangen, wobei abhängig von dem Signal das Schaltelement schaltbar ist. Beispielsweise kann von einer zentralen Steuerungseinheit, die wenigstens einen Sender aufweist, ein Signal an das Modul übertragen werden. Das Signal kann beispielsweise dazu dienen, das Modul zu aktivieren oder zu deaktivieren. Alternativ kann das Signal auch einen komplexeren Aufbau aufweisen, um beispielsweise eine Mehrzahl von Strömungsbeeinflussungselementen auf einem Modul oder eine Mehrzahl von Modulen teilweise zu aktivieren und/oder zu deaktivieren. Alternativ kann mit Hilfe eines Signals auch die Spannung und/oder Amplitude eines oder mehrerer Strömungsbeeinflussungselemente gesteuert werden. Dies hat den Vorteil, dass das Modul individuell gesteuert werden kann.

Gemäß einer bevorzugten Ausführungsform weist das Modul wenigstens einen Sender auf. Der Sender ist eingerichtet, ein Signal an einen Empfänger zu senden, wobei das Signal wenigstens Informationen über die von dem Modul erfassten Parametern umfasst. Das Signal umfasst beispielsweise Informationen über Druck, Temperatur und/oder Feuchtigkeit die durch den Fluiden auf das Modul einwirken. Anhand der übermittelten Parameter kann beispielsweise das Steuerelement ermitteln, ob und wie die hydrodynamische Beschleunigung des vorbeiströmenden Fluiden angepasst werden kann. Dies hat den Vorteil, dass das Modul individuell gesteuert werden kann.

Gemäß einer weiteren Ausführungsform weist das Modul wenigstens einen Empfänger und wenigstens einen Sender auf. Der Empfänger und der Sender weisen vorzugsweise die gleichen Eigenschaften auf, wie die zuvor beschriebenen Empfänger und Sender.

Gemäß einer bevorzugten Ausführungsform weist das Modul wenigstens einen Sensor auf. Der Sensor ist eingerichtet, Informationen über das Modul, Informationen über den Fluiden und /oder Informationen über die Umgebung des Moduls zu erfassen. Der Sensor kann beispielsweise mehrere Teilsensoren aufweisen, die geeignet sind Informationen über das Modul, Informationen über den Fluiden und /oder Informationen über die Umgebung des Moduls zu erfassen. Dies hat den Vorteil, dass das Modul anhand der Informationen über das Modul, Informationen über den Fluiden und /oder Informationen über die Umgebung des Moduls die Richtung und/oder Geschwindigkeit des Fluiden gezielt beeinflussen kann.

Gemäß einer weiteren Ausführungsform ist der Sensor ein Druck-, Temperatur- und/oder Feuchtigkeitssensor.

Der Drucksensor erfasst den Druck des vorbeiströmenden Fluiden. Dies hat den Vorteil, dass das Modul über den Druck des vorbeiströmenden Fluiden an dem Sensor Informationen erhält und gezielt die Richtung und/oder Geschwindigkeit des Fluiden beeinflussen kann. Abhängig von dem erfassten Druck kann das Modul die Spannung zur Erzeugung des lonenstroms, falls notwendig, anpassen.

Der Temperatursensor erfasst die Temperatur des an dem Modul vorbeiströmenden Fluiden. Dies hat den Vorteil, dass das Modul über die Temperatur des vorbeiströmenden Fluiden an dem Sensor Informationen erhält. Abhängig von der erfassten Temperatur kann das Modul die Spannung zur Erzeugung des lonenstroms, falls notwendig, anpassen.

Der Feuchtigkeitssensor erfasst die Feuchtigkeit des an dem Modul vorbeiströmenden Fluiden. Dies hat den Vorteil, dass das Modul über die Feuchtigkeit des vorbeiströmenden Fluiden an dem Sensor Informationen erhält. Abhängig von der erfassten Feuchtigkeit kann das Modul die Spannung zur Erzeugung des lonenstroms, falls notwendig, anpassen.

Gemäß einer bevorzugten Ausführungsform erfolgt die Ermittlung eines auf das Modul einwirkenden Drucks, einer Temperatur und/oder einer Feuchtigkeit durch den vorbeiströmende Fluiden durch das Strömungsbeeinflussungselement und/oder einen separaten Sensor. Bei der Erfassung des auf das Modul einwirkenden Drucks, Temperatur und/oder Feuchtigkeit durch das Strömungsbeeinflussungselement ist kein weiterer Sensor notwendig, so dass das Modul in seinen geometrischen Abmessungen sehr klein gehalten werden kann. Alternativ kann die Erfassung eines oder mehrerer Parameter ergänzend oder alternativ durch einen separaten Sensor erfolgen.

Gemäß einer bevorzugten Ausführungsform weist das Modul einen Beschleunigungssensor und/oder einen Lagesensor auf. Mit Hilfe des Beschleunigungssensors kann beispielsweise das Modul bei Ermittlung einer vorbestimmten Mindestbeschleunigung aktiviert werden. Bei Vorliegen einer negativen Beschleunigung kann das Modul beispielsweise deaktiviert werden oder umgekehrt. Mit Hilfe des Lagesensors kann beispielsweise die Lage des Moduls ermittelt werden, wobei das Modul bei bestimmten Orientierungen aktiviert bzw. deaktiviert werden kann. Der Beschleunigungssensor und/oder der Lagesensor können beispielsweise in MEMS-Technologie ausgeführt sein.

Gemäß einer bevorzugten Ausführungsform weist das Modul ein Steuerelement auf. Das Steuerelement ist eingerichtet, abhängig von der erfassten Information die hydrodynamische Beschleunigung des vorbeiströmenden Fluiden anzupassen. Das Steuerelement empfängt die durch beispielsweise einen Sensor auf dem Modul erfassten Informationen und steuert das aktive Strömungsbeeinflussungselement und/oder die Mehrzahl der aktiven Strömungsbeeinflussungselemente derart, dass die Beschleunigung des vorbeiströmenden Fluiden angepasst, bzw. verändert wird. Dies hat den Vorteil, dass das Modul individuell gesteuert werden kann.

Gemäß einer bevorzugten Ausführungsform weist das Modul weiter wenigstens ein Schaltelement zur Aktivierung und/oder Deaktivierung des Moduls auf. Ein Schaltelement kann alternativ auch für zwei oder mehrere Module ausgeführt sein. Über das Schaltelement lassen sich somit zwei oder mehrere Module aktivieren und/oder deaktivieren. Dies hat den Vorteil, dass das Modul gezielt aktiviert oder deaktiviert werden kann und somit individuell gesteuert werden kann.

Die Bezeichnung "Schaltelement" kann als jede Art von Vorrichtung verstanden werden, die geeignet ist, eine Verbindung von einem unterbrochenen Zustand in einen verbundenen Zustand zu verändern. Hierunter kann auch eine einseitig offene Verbindung zu verstehen sein, die beispielsweise durch anschließen des Moduls an beispielsweise eine elektronische Einheit zur Steuerung dauerhaft oder reversibel geschlossen werden kann.

Gemäß einer bevorzugten Ausführungsform sind der Spannungswandler, das Schaltelement, das Strömungsbeeinflussungselement, der Sensor, der Empfänger, der Sender und/oder das Steuerelement als MEMS (Mikroelektromechanisches System) -Struktur ausgeführt. Durch die Ausführung vorzugsweise eines Großteils der Komponenten des Moduls als MEMS-Struktur kann das Modul in seinen geometrischen Abmessungen sehr gering gehalten werden.

Weiter wird ein Modularray, aufweisend eine Mehrzahl von zuvor beschriebenen mikroelektronischen Modulen angegeben. Durch die Anordnung einer Mehrzahl der Module in einem Array kann der hydrodynamische Effekt verstärkt werden und/oder gezielt ausgerichtet eingesetzt werden.

Gemäß einer Ausführungsform können auch mehrere mikroelektronische Module auf einem gemeinsamen dünnschichtigen flächigen Substrat angeordnet sein.

Gemäß einer bevorzugten Ausführungsform weisen die aktiven und/oder passiven Strömungsbeeinflussungselemente der Mehrzahl der mikroelektronischen Module wenigstens teilweise eine unterschiedliche Orientierung auf. Durch eine wenigstens teilweise unterschiedliche Orientierung der Module, und damit der aktiven und/oder passiven Strömungsbeeinflussungselemente der Module kann durch den hydrodynamischen Effekt die Richtung und/oder die Geschwindigkeit eines die Anordnung um- und/oder überströmenden Fluiden gezielt beeinflusst werden.

Die aktiven Strömungsbeeinflussungselemente können durch passive Strömungsbeeinflussungselemente, genauer gesagt passive Strukturen in ihrer Wirkung unterstützt oder verstärkt werden. Diese passiven Strukturen können 3D mikrotechnische passive und/oder resonante Strukturen sein, die die generierte Strömung lokal beeinflussen, vorzugsweise verwirbeln, kanalisieren oder lokal umlenken können.

Gemäß einer bevorzugten Ausführungsform weist das Modularray ein oder mehrere Schaltelemente auf, die eingerichtet sind, ein oder mehrere Strömungsbeeinflussungselemente des Modularrays zu aktivieren und/oder zu deaktivieren. Dies hat den Vorteil, dass das Modularray individuell gesteuert werden kann und die geometrischen Abmessungen je nach Anwendung gering gehalten werden können.

Weiter wird eine Anordnung wenigstens eines zuvor beschriebenen mikroelektronischen Moduls oder wenigstens eines zuvor beschriebenen Modularrays auf einer Oberfläche eines Fahrzeugs angegeben. Durch den Einsatz wenigstens eines Moduls oder wenigstens eines Modularrays können beispielsweise Effekte im Bereich der Grenzschicht, die durch die Um- bzw. Überströmung einer Oberfläche eines Fahrzeugs auftreten, gezielt in der Richtung und/oder Geschwindigkeit beeinflusst werden.

Gemäß einer bevorzugten Ausführungsform ist das Fahrzeug ein Luftfahrzeug, ein Wasserfahrzeug oder ein Landfahrzeug. Durch die Anordnung wenigstens eines Moduls oder wenigstens eines Modularrays können Fluide in der Richtung und/oder Geschwindigkeit positiv beeinflusst werden, so dass beispielsweise ein Strömungswiderstand reduziert werden kann und dadurch Treibstoff bzw. Energie, der zum Antrieb des Fahrzeugs eingesetzt wird, eingespart werden.

Weiter wird ein Verfahren zur Beeinflussung einer Strömung eines Fluiden unter Verwendung wenigstens eines zuvor beschriebenen mikroelektronischen Moduls oder wenigstens eines Modularrays angegeben. Bei dem Verfahren wird die Strömung eines eine Oberfläche des Moduls oder Modularrays um- und/oder überströmenden Fluiden bezüglich dessen Richtung und/oder Geschwindigkeit beeinflusst. Bei dem Verfahren wird eine bereitgestellte erste Spannung in eine höhere, niedrigere oder identische zweite Spannung umgewandelt. Weiter wird bei dem Verfahren eine hydrodynamische Beschleunigung in Abhängigkeit von der zweiten Spannung erzeugt. Bei dem Verfahren wird weiter die Richtung und/oder die Geschwindigkeit des Fluiden durch die hydrodynamische Beschleunigung beeinflusst.

In den Zeichnungen beziehen sich im Allgemeinen gleiche Bezugszeichen auf die gleichen Teile über die verschiedenen Ansichten hinweg. Die Zeichnungen sind nicht notwendigerweise maßstabsgetreu; Wert wird stattdessen im Allgemeinen auf die Veranschaulichung der Prinzipien der Erfindung gelegt. In der folgenden Beschreibung werden verschiedene Ausführungsformen der Erfindung beschrieben unter Bezugnahme auf die folgenden Zeichnungen, in denen:
- FIG. 1: eine erste Ausführungsform eines mikroelektronischen Moduls zeigt;
- FIG. 2: ein Modularray aufweisend eine Mehrzahl von mikroelektronischen Modulen zeigt;
- FIG. 3: die Anordnung einer Mehrzahl mikroelektronischer Module auf der Oberfläche eines Flugzeugs zeigt; und
- FIG. 4: ein Flussdiagramm eines Verfahrens zur Beeinflussung einer Strömung eines Fluiden zeigt.

Die folgende detaillierte Beschreibung nimmt Bezug auf die beigefügten Zeichnungen, welche zur Erläuterung spezifische Details und Ausführungsformen zeigen, in welchem die Erfindung praktiziert werden kann.

Das Wort "beispielhaft" wird hierin verwendet mit der Bedeutung "als ein Beispiel, Fall oder Veranschaulichung dienend". Jede Ausführungsform oder Ausgestaltung, die hierin als "beispielhaft" beschrieben ist, ist nicht notwendigerweise als bevorzugt oder vorteilhaft gegenüber anderen Ausführungsformen oder Ausgestaltungen auszulegen.

In der folgenden ausführlichen Beschreibung wird auf die beigefügten Zeichnungen Bezug genommen, die einen Teil dieser Beschreibung bilden und in denen zur Veranschaulichung spezifische Ausführungsformen gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsformen in einer Anzahl verschiedener Orientierungen positioniert werden können, dient die Richtungsterminologie zur Veranschaulichung und ist auf keinerlei Weise einschränkend. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.
Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

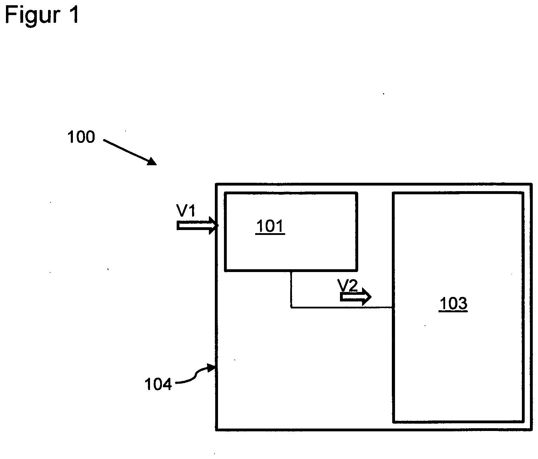

Figur 1 zeigt eine erste Ausführungsform eines mikroelektronischen Moduls 100 zur Beeinflussung einer Strömung eines Fluiden. Das Modul 100 weist einen Spannungswandler 101 zur Umwandlung einer bereitgestellten ersten Spannung V1 in eine höhere oder niedrigere zweite Spannung V2 auf. Weiter weist das Modul 100 ein aktives Strömungsbeeinflussungselement 103, zur Beeinflussung der Richtung und/oder der Geschwindigkeit eines das aktive Strömungsbeeinflussungselement 103 um- und/oder überströmenden Fluiden auf. Der Spannungswandler 101 und das aktive Strömungsbeeinflussungselement 103 des Moduls 100 sind auf einem dünnschichtigen flächigem Substrat 104 angeordnet. Der Spannungswandler 101 und das Strömungsbeeinflussungselement 103 des Moduls 100 sind miteinander elektrisch gekoppelt. Die Beeinflussung der Richtung und/oder der Geschwindigkeit des Fluiden ist abhängig von einer hydrodynamischen Beschleunigung in Abhängigkeit von der von dem Spannungswandler 101 bereitgestellten zweiten Spannung V2 an das Strömungsbeeinflussungselement 103. Neben dem aktiven Strömungsbeeinflussungselement 103 kann auch ein weiteres passives Strömungsbeeinflussungselement (nicht dargestellt), beispielsweise eine passive dreidimensionale Struktur auf dem Modul 100 angeordnet sein. Das Modul kann zur gezielten Aktivierung und/oder Deaktivierung des Strömungsbeeinflussungselements 103 ein Schaltelement (nicht dargestellt) aufweisen.

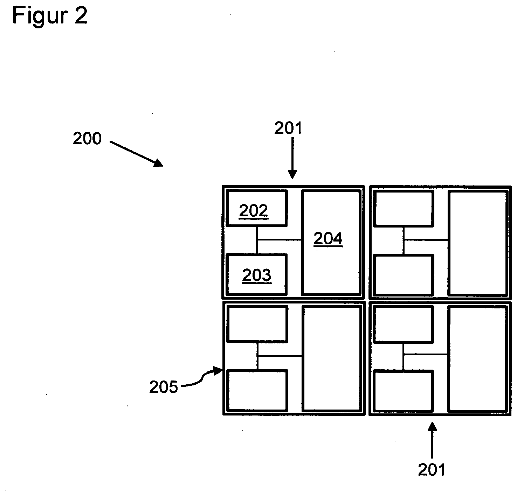

Figur 2 zeigt eine Ausführungsform eines Modularrays 200 aufweisend eine Mehrzahl von mikroelektronischen Modulen 201. Jedes der mikroelektronischen Module 201 weist einen Spannungswandler 202, ein Schaltelement 203 und ein Strömungsbeeinflussungselement 204 auf einem dünnschichtigen flächigen Substrat 205 auf. Obwohl jedes der dargestellten Module 201 ein eigenes Schaltelement 204 aufweisen, kann gemäß einer alternativen Ausführungsform (nicht dargestellt) ein Schaltelement 204 auch für zwei oder mehrere Module 201 vorgesehen sein.

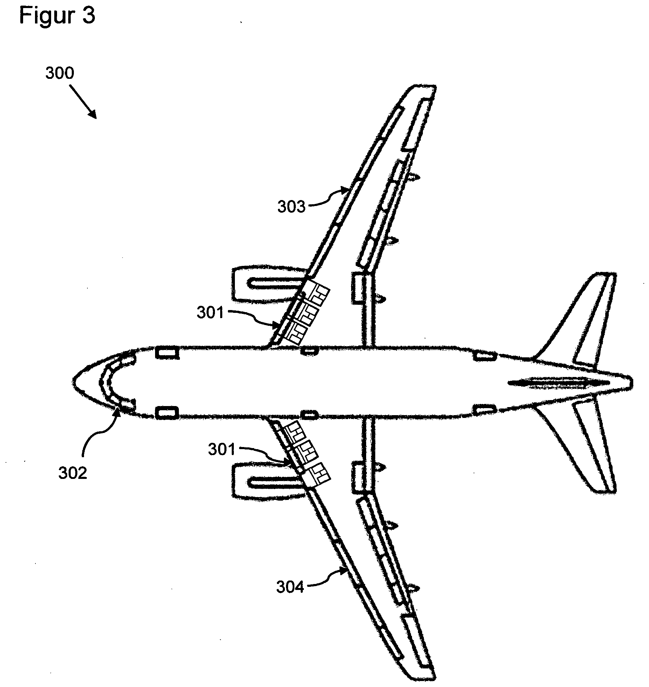

Figur 3 zeigt eine Ausführungsform einer Anordnung 300 einer Mehrzahl von mikroelektronischen Modulen 301 auf der Oberfläche eines Flugzeugs 302. Auf den Tragflächen 303, 304 des Flugzeugs 302 sind in der dargestellten Ausführungsform im Bereich der Tragflächenvorderkante mehrere mikroelektronische Module 301 angeordnet, um Reibungsverluste an der Tragflächenvorderkante zu reduzieren.

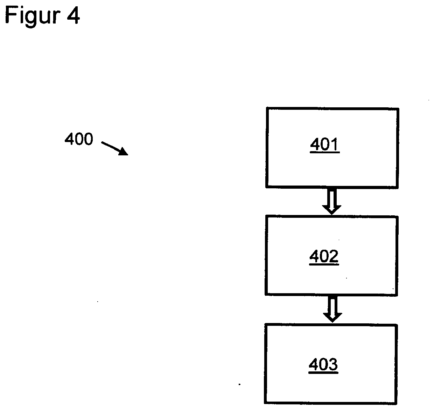

Figur 4 zeigt ein Flussdiagramm 400 einer Ausführungsform eins Verfahrens zur Beeinflussung einer Strömung eines Fluiden unter Verwendung wenigstens eines Mikroelektronischen-Moduls oder wenigstens eines Modularrays. In Schritt 401 wird eine erste Spannung bereitgestellt, die in eine zweite Spannung umgewandelt wird, die höher oder niedriger ist, wie die erste Spannung. Mit Hilfe der zweiten Spannung wird in Schritt 402 eine hydrodynamische Beschleunigung in Abhängigkeit von der zweiten Spannung erzeugt. In Schritt 403 werden die Richtung und/oder die Geschwindigkeit des Fluiden durch die erzeugte hydrodynamische Beschleunigung beeinflusst.
Obwohl die Erfindung vor allem unter Bezugnahme auf bestimmte Ausführungsformen gezeigt und beschrieben worden ist, sollte von denjenigen, die mit dem Fachgebiet vertraut sind, verstanden werden, dass zahlreiche Änderungen bezüglich Ausgestaltung und Details daran vorgenommen werden können, ohne von der Erfindung, wie durch die angefügten Ansprüche definiert, abzuweichen. Der Bereich der Erfindung wird somit durch die angefügten Ansprüche bestimmt, und es ist daher beabsichtigt, dass sämtliche Änderungen, welche unter den Wortsinn oder den Äquivalenzbereich der Ansprüche fallen, umfasst werden.

### Bezugszeichenliste

- 100, 201, 301: Modul
- 101, 202: Spannungswandler
- 103, 204: aktives Strömungsbeeinflussungselement
- 104, 205: Substrat
- 200: Modularray
- 203: Schaltelement
- 300: Anordnung
- 302: Flugzeug
- 303,304: Tragfläche
- 400: Flussdiagramm
- 401 - 403: Verfahrensschritte

- V1: erste Spannung
- V2: zweite Spannung

## Patentansprüche

1. Mikroelektronisches Modul (100) zur Beeinflussung einer Strömung eines Fluiden, aufweisend:
wenigstens einen Spannungswandler (101) zur Umwandlung einer bereitgestellten ersten Spannung (V1) in eine höhere oder niedrigere zweite Spannung (V2);
wenigstens ein aktives Strömungsbeeinflussungselement (103) zur Beeinflussung der Richtung und/oder der Geschwindigkeit eines das aktive Strömungsbeeinflussungselement (103) um- und/oder überströmenden Fluiden;
wobei wenigstens der Spannungswandler (101) und das aktive Strömungsbeeinflussungselement (103) auf einem dünnschichtigen flächigen Substrat (104) angeordnet sind; und
wobei die Beeinflussung der Richtung und/oder der Geschwindigkeit des Fluiden abhängig ist von einer hydrodynamischen Beschleunigung in Abhängigkeit von der von dem Spannungswandler (101) bereitgestellten zweiten Spannung (V2) an das aktive Strömungsbeeinflussungselement (103).

2. Mikroelektronisches Modul nach Anspruch 1,
wobei der Spannungswandler (101) einen piezoelektrischen Transformator aufweist.

3. Mikroelektronisches Modul nach einem der vorherstehenden Ansprüche,
wobei die bereitgestellte erste Spannung (V1) für den Spannungswandler (101) wenigstens teilweise über eine externe Spannungsquelle bereitgestellt wird.

4. Mikroelektronisches Modul nach einem der vorherstehenden Ansprüche,
wobei das Substrat (104) weiter ein Energieerzeugungselement zur Erzeugung wenigstens eines Teils der bereitzustellenden ersten Spannung (V1) aufweist,
wobei das Energieerzeugungselement eine Solarzellenanordnung aufweisen kann.

5. Mikroelektronisches Modul nach einem der vorherstehenden Ansprüche,
wobei das dünnschichtige flächige Substrat (104) eine flexible und/oder mehrdimensional verformbare Folie oder ein Gitter ist.

6. Mikroelektronisches Modul nach einem der vorherstehenden Ansprüche,
wobei das Modul (100) eine Mehrzahl von aktiven Strömungsbeeinflussungselementen (103) aufweist, wobei die aktiven Strömungsbeeinflussungselemente (103) eine unterschiedliche und/oder identische Orientierung aufweisen; oder
wobei das Modul (100) eine Mehrzahl von aktiven Strömungsbeeinflussungselementen (103) und wenigstens ein passives Strömungsbeeinflussungselement aufweist, wobei die aktiven und/oder passiven Strömungsbeeinflussungselemente (103) eine unterschiedliche und/oder identische Orientierung aufweisen.

7. Mikroelektronisches Modul nach Anspruch 6,
wobei die Orientierung, eine zeitlich abhängige und/oder eine spannungsamplitudenabhängige Ansteuerung der Mehrzahl von aktiven Strömungsbeeinflussungselementen (103) und/oder die Orientierung der passiven Strömungsbeeinflussungselemente die Richtung der Beeinflussung auf den Fluiden bestimmt.

8. Mikroelektronisches Modul nach einem der vorherstehenden Ansprüche,
wobei das Modul (100) wenigstens einen Empfänger aufweist, der eingerichtet ist ein Signal zu empfangen, wobei abhängig von dem Signal das Schaltelement (102) schaltbar ist; und/oder
wobei das Modul (100) wenigstens einen Sender aufweist, der eingerichtet ist, ein Signal an einen Empfänger zu senden, wobei das Signal wenigstens Informationen über die von dem Modul (100) erfassten Parametern umfasst.

9. Mikroelektronisches Modul nach einem der vorherstehenden Ansprüche,
wobei das Modul (100) wenigstens einen Sensor aufweist, der eingerichtet ist, Informationen über das Modul (100), Informationen über den Fluiden und /oder Informationen über die Umgebung des Moduls (100) zu erfassen, wobei der Sensor ein Druck-, Temperatur- und/oder Feuchtigkeitssensor ist.

10. Mikroelektronisches Modul nach einem der vorherstehenden Ansprüche,
wobei die Ermittlung eines auf das Modul (100) einwirkenden Drucks, einer Temperatur und/oder einer Feuchtigkeit durch den vorbeiströmende Fluiden durch das Strömungsbeeinflussungselement (103) und/oder einen separaten Sensor erfolgt.

11. Mikroelektronisches Modul nach einem der vorherstehenden Ansprüche,
wobei das Modul (100) ein Steuerelement aufweist, das eingerichtet ist, abhängig von der erfassten Information die hydrodynamische Beschleunigung des vorbeiströmenden Fluiden anzupassen; und/oder
wobei das Modul (100) wenigstens ein Schaltelement (102) zur Aktivierung und/oder Deaktivierung des Moduls (100) aufweist.

12. Mikroelektronisches Modul nach einem der vorherstehenden Ansprüche,
wobei der Spannungswandler (101), das Schaltelement (102), das Strömungsbeeinflussungselement (103), der Sensor, der Empfänger, der Sender und/oder das Steuerelement als MEMS-Struktur ausgeführt sind.

13. Modularray (200), aufweisend eine Mehrzahl von mikroelektronischen Modulen (201) nach einem der vorherstehenden Ansprüche,
wobei die aktiven und/oder passiven Strömungsbeeinflussungselemente (204) der Mehrzahl der mikroelektronischen Module (201) wenigstens teilweise eine unterschiedliche Orientierung aufweisen.

14. Anordnung (300) wenigstens eines mikroelektronischen Moduls (301) oder wenigstens eines Modularrays nach einem der vorherstehenden Ansprüche auf einer Oberfläche eines Fahrzeugs (302),
wobei das Fahrzeug (302) ein Luftfahrzeug, ein Wasserfahrzeug oder ein Landfahrzeug ist.

15. Verfahren (400) zur Beeinflussung einer Strömung eines Fluiden unter Verwendung wenigstens eines mikroelektronischen Moduls oder wenigstens eines Modularrays nach einem der vorherstehenden Ansprüche,
wobei die Strömung eines eine Oberfläche des Moduls oder Modularrays um- und/oder überströmenden Fluiden bezüglich dessen Richtung und/oder Geschwindigkeit beeinflusst wird, aufweisend die Schritte:
Umwandeln einer bereitgestellten ersten Spannung in eine höhere oder niedrigere zweite Spannung (401);
Erzeugen einer hydrodynamische Beschleunigung in Abhängigkeit von der zweiten Spannung (402); und
Beeinflussen der Richtung und/oder der Geschwindigkeit des Fluiden durch die hydrodynamische Beschleunigung (403).

## Claims

1. Microelectronic module (100) for influencing a flow of a fluid, comprising:
at least one voltage converter (101) for converting a provided first voltage (V1) into a higher, lower, or identical second voltage (V2);
at least one active flow-influencing element (103) for influencing the direction and/or speed of a fluid which is flowing around and/or over the active flow-influencing element (103);
wherein at least the voltage converter (101) and the active flow-influencing element (103) are disposed on a thin-film, planar substrate (104); and
wherein the influencing of the direction and/or the speed of the fluid is dependent on a hydrodynamic acceleration as a function of the second voltage (V2) provided by the voltage converter (101) at the active flow-influencing element (103).

2. Microelectronic module according to Claim 1,
wherein the voltage converter (101) comprises a piezoelectric transformer.

3. Microelectronic module according to one of the preceding claims,
wherein the provided first voltage (V1) for the voltage converter (101) is provided, at least partially, via an external voltage source.

4. Microelectronic module according to one of the preceding claims,
wherein the substrate (104) further comprises an energy-generating element for generating at least a portion of the first voltage (V1) to be provided, or
wherein the substrate (104) further comprises an energy-generating element for generating at least a portion of the first voltage (V1) to be provided, wherein the energy-generating element comprises a solar cell arrangement.

5. Microelectronic module according to one of the preceding claims,
wherein the thin-film, planar substrate (104) is a flexible and/or multidimensionally deformable film or lattice.

6. Microelectronic module according to one of the preceding claims,
wherein the module (100) comprises a plurality of active flow-influencing elements (103), wherein the active flow-influencing elements (103) have a different orientation and/or an identical orientation; or
wherein the module (100) comprises a plurality of active flow-influencing elements (103) and at least one passive flow-influencing element, wherein the active and/or passive flow-influencing elements (103) have a different orientation and/or an identical orientation.

7. Microelectronic module according to Claim 6,
wherein the orientation, a time-dependent and/or a voltage amplitude-dependent control of the plurality of active flow-influencing elements (103) and/or the orientation of the passive flow-influencing elements determine/determines the direction of the influence on the fluid.

8. Microelectronic module according to one of the preceding claims,
wherein the module (100) comprises at least one receiver which is designed for receiving a signal, wherein the switching element (102) can be switched depending on the signal; and/or
wherein the module (100) comprises at least one transmitter which is designed for transmitting a signal to a receiver, wherein the signal includes at least information regarding the parameters detected by the module (100).

9. Microelectronic module according to one of the preceding claims,
wherein the module (100) comprises at least one sensor which is designed for gathering information regarding the module (100), information regarding the fluid and/or information regarding the environment of the module (100), wherein the sensor is a pressure sensor, a temperature sensor and/or a humidity sensor.

10. Microelectronic module according to one of the preceding claims,
wherein the determination of a pressure, a temperature and/or a humidity acting on the module (100) due to the fluid flowing past is carried out by the flow-influencing element (103) and/or a separate sensor.

11. Microelectronic module according to one of the preceding claims,
wherein the module (100) comprises a control element which is designed for adjusting the hydrodynamic acceleration of the passing flow of fluid depending on the gathered information; and/or
wherein the module (100) comprises at least one switching element (102) for activating and/or deactivating the module (100).

12. Microelectronic module according to one of the preceding claims,
wherein the voltage converter (101), the switching element (102), the flow-influencing element (103), the sensor, the receiver, the transmitter and/or the control element are designed as a MEMS structure.

13. Module array (200) comprising a plurality of microelectronic modules (201) according to one of the preceding claims,
wherein the active and/or passive flow-influencing elements (204) of the plurality of microelectronic modules (201) have, at least partially, a different orientation.

14. Arrangement (300) at least of a microelectronic module (301) or at least a module array according to one of the preceding claims on a surface of a vehicle (302),
wherein the vehicle (302) is an aircraft, a watercraft, or a ground vehicle.

15. Method (400) for influencing a flow of a fluid using at least one microelectronic module or at least one module array according to one of the preceding claims,
wherein the direction and/or speed of the flow of a fluid flowing around and/or over a surface of the module or module array is influenced, including the steps:
converting a provided first voltage into a higher, lower, or identical second voltage (401);
generating a hydrodynamic acceleration as a function of the second voltage (402); and
influencing the direction and/or the speed of the fluid by means of the hydrodynamic acceleration (403).

## Revendications

1. Module microélectronique (100) destiné à influencer un écoulement d'un fluide, comportant :
au moins un convertisseur de tension (101) destiné à convertir une première tension (V1) fournie en une seconde tension (V2) supérieure ou inférieure ;
au moins un élément actif influençant l'écoulement (103) destiné à influencer la direction et/ou la vitesse d'un fluide circulant autour et/ou sur l'élément actif influençant l'écoulement (103) ;
dans lequel au moins le convertisseur de tension (101) et l'élément actif influençant l'écoulement (103) sont disposés sur un substrat en couche mince (104) ; et
dans lequel l'influence de la direction et/ou de la vitesse du fluide dépend d'une accélération hydrodynamique fonction de la seconde tension (V2) fournie par le convertisseur de tension (101) à l'élément actif influençant l'écoulement (103).

2. Module microélectronique selon la revendication 1,
dans lequel le convertisseur de tension (101) comprend un transformateur piézoélectrique.

3. Module microélectronique selon l'une des revendications précédentes,
dans lequel la première tension (V1) fournie au convertisseur de tension (101) est fournie au moins partiellement par l'intermédiaire d'une source de tension externe.

4. Module microélectronique selon l'une des revendications précédentes,
dans lequel le substrat (104) comprend en outre un élément générateur d'énergie destiné à générer au moins une partie de la première tension (V1) devant être fournie, ou
dans lequel le substrat (104) comprend en outre un élément générateur d'énergie destiné à générer au moins une partie de la première tension (V1)devant être fournie,
dans lequel l'élément générateur d'énergie peut comporter un système de cellules solaires.

5. Module microélectronique selon l'une des revendications précédentes,
dans lequel le substrat plan en couche mince (104) est un film ou un treillis flexible et/ou déformable à plusieurs dimensions.

6. Module microélectronique selon l'une des revendications précédentes,
dans lequel le module (100) comporte une pluralité d'éléments actifs influençant l'écoulement (103), dans lequel les éléments actifs influençant l'écoulement (103) présentent des orientations différentes et/ou identiques ; ou
dans lequel le module (100) comporte une pluralité d'éléments actifs influençant l'écoulement (103) et au moins un élément passif influençant l'écoulement, dans lequel les éléments actifs et/ou passifs influençant l'écoulement (103) présentent des orientations différentes et/ou identiques.

7. Module microélectronique selon la revendication 6,
dans lequel l'orientation détermine une commande dépendant du temps et/ou dépendant de l'amplitude de tension de la pluralité d'éléments actifs influençant l'écoulement (103) et/ou l'orientation des éléments passifs influençant l'écoulement détermine la direction de l'influence sur les fluides.

8. Module microélectronique selon l'une des revendications précédentes,
dans lequel le module (100) comporte au moins un récepteur conçu pour recevoir un signal, dans lequel l'élément de commutation (102) peut être amené à commuter en fonction du signal ; et/ou
dans lequel le module (100) comporte au moins un émetteur conçu pour émettre un signal vers un récepteur, dans lequel le signal comprend au moins des informations concernant les paramètres détectés par le module (100).

9. Module microélectronique selon l'une des revendications précédentes,
dans lequel le module (100) comporte au moins un capteur conçu pour acquérir des informations concernant le module (100), des informations concernant les fluides et/ou des informations concernant l'environnement du module (100), dans lequel le capteur est un capteur de pression, de température et/ou d'humidité.

10. Module microélectronique selon l'une des revendications précédentes,
dans lequel la détermination d'une pression, d'une température et/ou d'une humidité agissant sur le module (100) est effectuée par l'intermédiaire du fluide circulant à travers l'élément influençant l'écoulement (103) et/ou d'un capteur séparé.

11. Module microélectronique selon l'une des revendications précédentes,
dans lequel le module (100) comporte un élément de commande conçu pour adapter l'accélération hydrodynamique du fluide en circulation en fonction de l'information acquise ; et/ou
dans lequel le module (100) comporte au moins un élément de commutation (102) destiné à activer et/ou désactiver le module (100).

12. Module microélectronique selon l'une des revendications précédentes,
dans lequel le convertisseur de tension (101), l'élément de commutation (102), l'élément influençant l'écoulement (103), le capteur, le récepteur, l'émetteur et/ou l'élément de commande sont réalisés sous la forme d'une structure MEMS.

13. Réseau de modules (200), comportant une pluralité de modules microélectroniques (201) selon l'une des revendications précédentes,
dans lequel les éléments actifs et/ou passifs influençant l'écoulement (204) de la pluralité de modules microélectroniques (201) présentent au moins partiellement des orientations différentes.

14. Système (300) constitué d'au moins un module microélectronique (301) ou d'au moins un réseau de modules selon l'une des revendications précédentes sur une surface d'un véhicule (302),
dans lequel le véhicule (302) est un aéronef, une embarcation ou un véhicule terrestre.

15. Procédé (400) destiné à influencer un écoulement d'un fluide au moyen d'au moins un module microélectronique ou d'au moins un réseau de modules selon l'une des revendications précédentes,
dans lequel l'écoulement d'un fluide circulant autour et/ou sur une surface du module ou du réseau de modules est influencé en ce qui concerne sa direction et/ou sa vitesse, comprenant les étapes suivantes :
convertir une première tension fournie en une seconde tension (401) supérieure ou inférieure ;
produire une accélération hydrodynamique en fonction de la seconde tension (402) ; et
influencer la direction et/ou la vitesse du fluide par l'intermédiaire de l'accélération hydrodynamique (403).
